# EUROPEAN PATENT APPLICATION

(11) **EP 4 492 932 A1**
(43) Date of publication of application: **15.01.2025**
(21) Application number: 23306198.5
(22) Date of filing: 12.07.2023
(51) Int. Cl.: H05K 7/14

(54) **MULTI-LEVEL MODULAR DATACENTER CONFIGURATION**

(71) Applicant: OVH, 59100 Roubaix (FR)
(72) Inventor: CHEHADE, Ali, 59283 Moncheaux (FR); BAUCHART, Grégory Francis Louis, 59150 Wattrelos (FR); MASRI, Charbel, 59000 Lille (FR)
(74) Representative: BCF Global

(57) **Abstract**

A multi-level modular datacenter and method of installation is presented. The multi-level modular datacenter including a lower containment unit housing a first assembly of data processing equipment, an upper containment unit housing a second assembly of data processing equipment, in which the upper containment unit is arranged to be aligned and vertically disposed directly above the lower containment unit. The multi-level modular datacenter further including at least one first support structure configured to support a respective underneath area of a lateral side portion of the second containment unit and at least one second support structure configured to support a respective underneath area of a corner portion of the second containment unit. The first and second support structures are arranged to receive all weight bearing forces of the second containment unit and provide a protective vertical isolation gap between the first and second containment units.

## Description

### FIELD OF TECHNOLOGY

The present technology relates to overall datacenter configurations, and in particular, to a multi-level modular datacenter configuration.

### BACKGROUND

In efforts to process vast amounts of data in near-real time, permanent datacenters house and service multitudes of racks containing electronic equipment, such as, computer server assemblies, specialized processors, memory components, high-speed network modules, *etc.* as well as supporting infrastructure equipment, such as, power facilities, air handling systems, liquid cooling structures, *etc.*

The market demand to service the ever-increasing data processing requirements eventually leads to the need of more datacenters. However, the initial investment costs along with the construction time associated with the installation of permanent datacenters can be prohibitive.

To counter the high cost of constructing permanent datacenters, various solutions have been proposed directed to the installation of "modular datacenters," in which datacenter electronic computing equipment and supporting infrastructure equipment are incorporated in movable trailers or shipping containers. Depending on data processing demands, multiple trailers/shipping containers may be deployed and arranged in different single level geometric configurations that spread across a sizeable area. Therefore, in contrast to permanent datacenters, modular datacenters provide substantial reductions in overall construction time and installation costs to provide speedier turn-key operations.

However, a situation may exist in which certain space-limited geographical areas having high data processing needs (*e*.*g*., urban areas, research campuses, *etc*.), may not be able to accommodate sprawling modular datacenter configurations. It may, therefore, be desirable to provide multiple modular datacenter configurations having smaller footprints.

It is to be noted that the subject matter discussed in the background section should not be assumed to be prior art merely as a result of its mention in the background section. Similarly, the issues mentioned in the background section should not be interpreted as having been recognized in the prior art.

### SUMMARY

It is an object of the present technology to alleviate at least some of the drawbacks that prevail in the prior art.

In addressing such drawbacks, the embodiments of the present disclosure provide a multi-level modular datacenter a lower containment unit configured to house a first assembly of data processing equipment and supporting infrastructure equipment; an upper containment unit configured to house a second assembly of data processing equipment and supporting infrastructure equipment, the upper containment unit arranged to be aligned and vertically disposed directly above the lower containment unit; at least one first support structure configured to support a respective underneath area of a lateral side portion of the second containment unit; and at least one second support structure configured to support a respective underneath area of a corner portion of the second containment unit. The at least one first and second support structures being arranged to: raise the second containment unit directly above the first containment unit and receive all weight bearing forces of the second containment unit, and provide a protective vertical isolation gap between the first and second containment units.

The multi-level modular datacenter provides that the protective vertical isolation gap comprises a vertical height displacement of approximately 100mm to approximately 500mm to provide a preventative air layer.

The multi-level modular datacenter also provides that the at least one first support structure manifests a general A-shaped configuration and further comprises a bracket member incorporating a cross member having flanged coupling portions disposed at both ends of the cross member; and an engagement planar member fixedly attached to the cross member, the engagement planar member configured to directly interface and supportively engage the respective underneath area of the lateral side portion of the second containment unit. Additionally, the engagement planar member includes at least one fastening element for securely attaching the engagement planar member to the underside lateral portion of the upper containment unit.

The multi-level modular datacenter also provides that the at least one first support structure incorporates at least one footplate member fixedly attached to a bottom end of each respective leg forming the A-shaped configuration of the at least one first support structure. Additionally, the at least one footplate member includes an extended portion to securely couple the at least one first support structure to an underside portion of the lower containment unit.

The multi-level modular datacenter further provides that the at least one footplate member is mounted to a positioning plate including upwardly protruding anchor elements of positioning plate serve to securely couple the first support structure to an underside portion of the lower containment unit. Additionally, the positioning plate is configured to accommodate one more tilting plates for lifting a side of the lower containment unit and tilting the lower containment unit accordingly.

The multi-level modular datacenter further provides that the at least one second support structure comprises a combined arrangement between the at least one first support structure and a second frame member manifesting a general A-shaped configuration.

The multi-level modular datacenter further provides that the second frame member is securely fastened to one of the flanged coupling portions of the bracket member of the at least one first support structure. Additionally, the secure fastening of the second frame member to one of the flanged coupling portions of the bracket member comprises a threaded bolt and nut combination.

Moreover, the embodiments of the present disclosure also provide an assembly method for a multilevel modular datacenter configuration comprising a lower containment unit and an upper containment unit disposed above the lower containment unit, in which the assembly method includes determining location placement of positioning plates in accordance with dimensions and location of corner portions of the lower containment unit; installing the positioning plates at the determined placement locations; mounting footplate members of first support structures onto the corresponding positioning plates; positioning and securely coupling the lower containment unit onto the positioning plates with the correspondingly mounted footplate members of the first support structures; attaching and securely fastening second frame members to the first support structures to provide second support structures that support the upper containment unit; and positioning and securely coupling the upper containment unit onto the second support structures, such that the upper containment unit is isolated from imparting any weight bearing forces onto the lower containment unit.

The multilevel modular datacenter assembly method further including determining whether tilting of a lateral side of the lower containment unit is required; and upon determining the requirement for tilting, installing tilting plates to the positioning plates to raise a corresponding lateral side of the lower containment unit.

Implementations of the present technology each have at least one of the above-mentioned objects and/or aspects, but may not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
FIG. 1A depicts a perspective view of a base multilevel modular datacenter configuration, in accordance with non-limiting embodiments of the present disclosure;
FIG. 1B depicts a side elevation view of the base multilevel modular datacenter configuration, in accordance with non-limiting embodiments of the present disclosure; FIG. 1C depicts a perspective view of a plurality of multilevel modular datacenter configurations aligned along a lateral direction, in accordance with non-limiting embodiments of the present disclosure;
FIGs. 2A, 2B depict perspective views of a first support structure, in accordance with non-limiting embodiments of the present disclosure;
FIG. 3 depicts a perspective view of a second support structure, in accordance with non-limiting embodiments of the present disclosure; and
FIG. 4 illustrates a method of assembly for multilevel modular datacenter configuration, in accordance with non-limiting embodiments of the present disclosure.

### DETAILED DESCRIPTION

The instant disclosure is directed to addressing at least some of the issues associated with space-limited geographical areas having high data processing needs that may not be able to accommodate sprawling modular datacenter configurations. In particular, the instant disclosure presents various embodiments that provide multiple modular datacenter configurations with smaller footprints.

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative systems embodying the principles of the present technology.

With these fundamentals in place, we will now consider some non-limiting examples to illustrate the implementations of the various inventive aspects of the present disclosure.

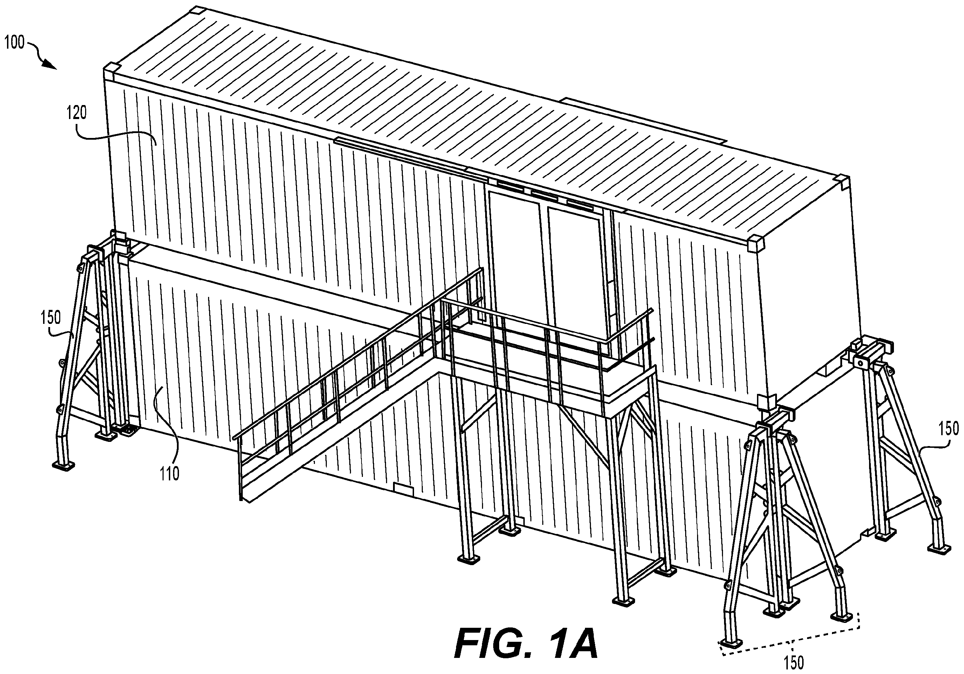

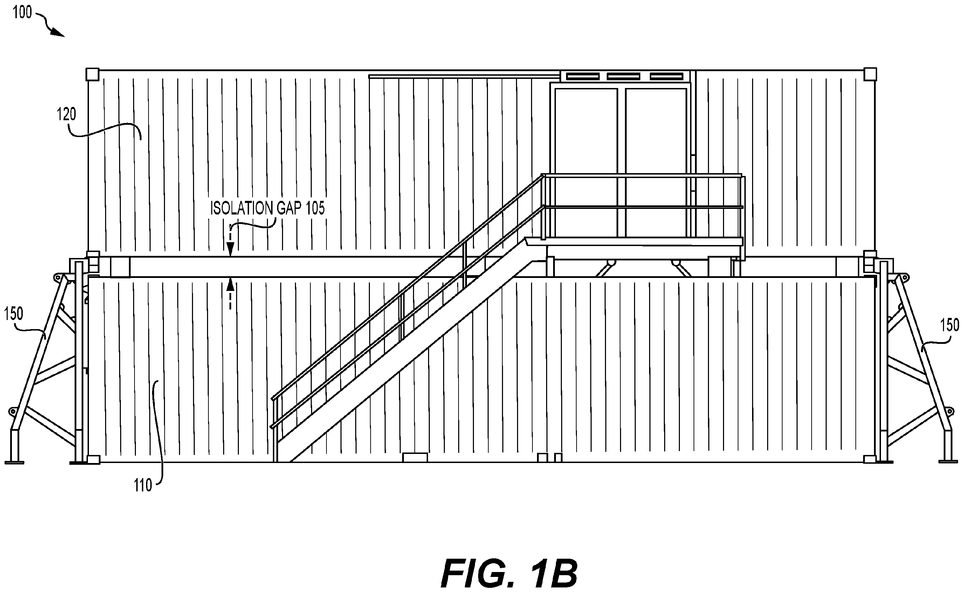

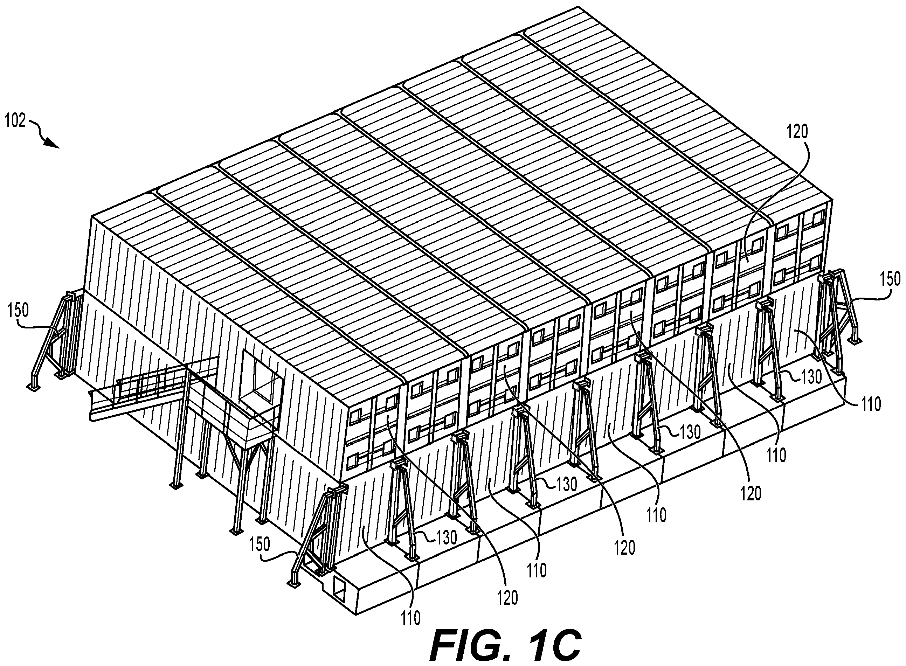

In particular, FIG. 1A depicts a perspective view of a base multilevel modular datacenter configuration **100,** FIG. 1B depicts a side elevation view of the base multilevel modular datacenter configuration **100,** and FIG. 1C depicts a perspective view of a plurality of multilevel modular datacenter configurations grouped as successive rows, respectively, in accordance with nonlimiting embodiments of the present disclosure.

As shown by the depicted embodiments, multilevel modular datacenter configuration **100** employs a vertically-stacked arrangement comprising a lower containment unit **110** and an upper containment unit **120** that is vertically aligned and disposed directly above the lower containment unit **110.** The containment units **110, 120** may be embodied by trailers, shipping containers, or other similarly-configured structures. The vertically-stacked arrangement of containment units **110, 120** provides the benefit of a performing high volume data processing operations within a relatively limited footprint.

With this said, the containment units **110, 120** are configured to house and service an assembly of multiple racks containing electronic equipment, such as, computer server assemblies, specialized processors, memory components, high-speed network modules, *etc.* along with supporting infrastructure equipment, such as, power facilities, air handling systems, liquid cooling structures, *etc.* It will be appreciated that each of the containment units **110, 120** may incorporate different components and equipment of the overall modular datacenter system or may duplicate the same components/equipment for redundancy purposes. As such, both the first and second containment units **110, 120** incorporate one or more openings (not shown) to enable ventilation of the data processing equipment as well as accommodate the routing of associated cabling and/or piping arrangements between the containment units **110, 120** and/or to external resources.

As shown in FIGs. 1A, 1B, the vertically-stacked multilevel modular datacenter configuration **100** employs support structures **150** proximately positioned along the underside of corner portions of upper containment unit **120.** Relatedly, as shown in FIG. 1C, the plurality of vertically-stacked multilevel modular datacenters configuration **102** may also employ support structures **130** proximately positioned along the underside of lateral portions of upper containment unit **120.** As described in greater detail below, in use, the upper containment unit **120** is not supported by the lower containment unit **110.** Rather, that the support structures **130, 150** function to carry and maintain the upper containment unit **120** above the lower containment unit **110.**

As best seen in FIG. 1B, the support structures **130, 150** are configured, and operate, to raise the upper containment unit **120** above the lower containment unit **110** to produce an isolation gap **105** between the lower containment unit **110** and the upper containment unit **120.** The isolation gap **105** offers several advantages: (a) prevents any weight bearing forces of the upper containment unit **120** from being imparted or directed onto the lower containment unit **110;** (b) provides a protective air layer against the spread of fire, water, and/or electrical hazards between the containment units **110, 120;** and (c) facilitates access by industrial equipment to install/deinstall containment units **110, 120.** The vertical height displacement of isolation gap **105** may depend from mechanical properties of the material constituting a bracket member **134** (described below), such that materials with higher mechanical tensile strength may allow for a smaller isolation gap **105** height displacement that for materials having lower mechanical tensile strength. The isolation gap **105** height displacement may be arranged to be between approx. 100 mm to approx. 500 mm.

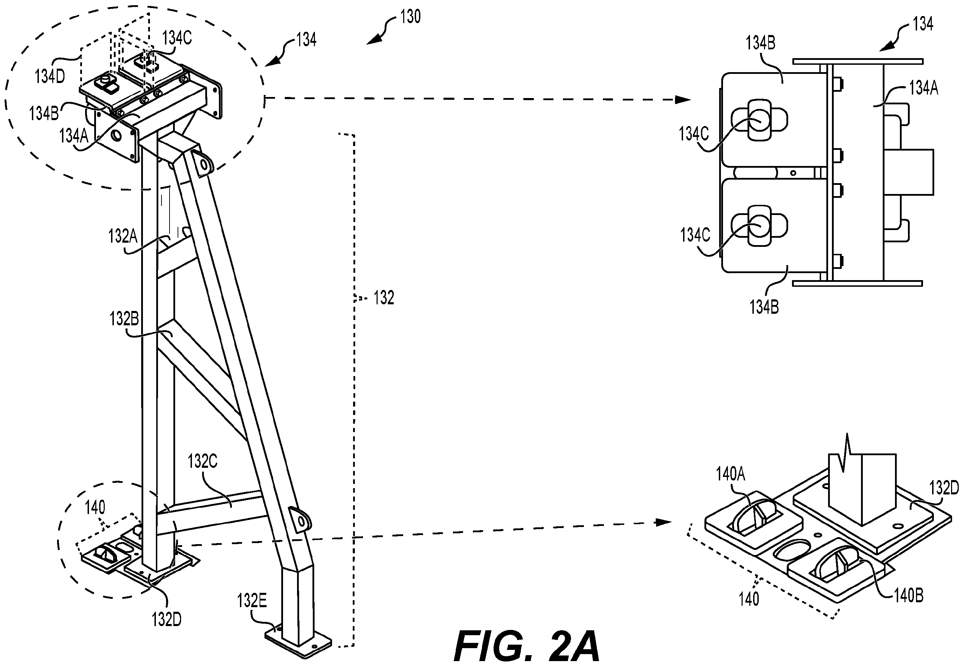

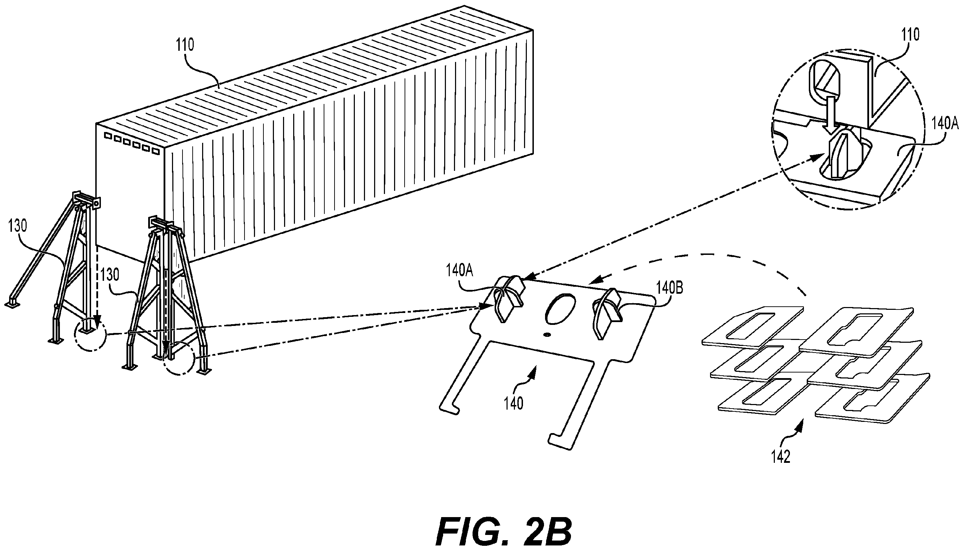

FIGs. 2A, 2B depict a perspective view of a first support structure **130** and corresponding footplate members, respectively, in accordance with non-limiting embodiments of the present disclosure. The first support structure **130** is configured, and operates, to support an underside of lateral portions of the upper containment unit **120,** as best seen in FIG. 1C. In the depicted nonlimiting embodiment, the first support structure **130** comprises a main frame member **132,** cross brace members **132A, 132B, 132C,** a bracket member **134,** and footplate members **132D, 132E.**

In the depicted nonlimiting embodiment of FIG. 2A, the main frame member **132** of the first support structure **130** manifests a general "A-shaped" configuration having one or more cross brace members **132A, 132B, 132C** disposed between the respective vertical legs forming the A-shaped configuration. The A-shaped configuration of the main frame member **132** provides stability and strength that is capable of handling the weight bearing force imparted by the lateral sides of the upper containment unit **120.** It will be appreciated that other shape configurations/designs of the main frame member **132** may be employed, provided that such other configurations are capable of handling the weight bearing force of upper containment unit **120.**

As shown, fixedly attached to a top end of the A-shaped main frame member **132** of the first support structure **130** is bracket member **134.** The bracket member **134** is configured, and operates, to engage an underside portion of a lateral side of the upper containment unit **120.** To this end, bracket member **134** comprises a cross member **134A** incorporating flanged coupling portions disposed at both ends and one or more engagement planar members **134B** fixedly attached to the cross member **134A.**

As best seen in the enlarged top view cutout of bracket member **134** in FIG. 2A, two engagement planar members **134B** are depicted that are configured to directly interface with, and engagingly support, an underside portion of a lateral side of a respective upper containment unit **120.** Each of the engagement planar members **134B** are configured to be removably attached to the first support structure **130** depending on the implementation scenarios. For example, in implementations where the first support structure **130** is to be installed to support a single upper containment unit **120** at a corner portion thereof, only one engagement planar member **134B** is needed to be coupled to the first support structure **130** while a second frame member **156** (described below) is fastened the first support structure **130.** And, in implementations where the first support structure **130** is to be installed to support two upper containment units **120** at respective corner portions thereof, two engagement planar members **134B** are installed and fastened the first support structure **130** (i.e. one engagement planar member **134B** for each of the upper containment unit **120).** It can be said that an installation of the multilevel modular datacenter configuration **100** may be evolutionary. Indeed, support structures **130** disposed at corners thereof may be adjusted by disconnecting a second frame member **156** therefrom, and fastening an additional engagement planar members **134B** thereto in order to support an additional upper containment unit **120.**

The engagement planar member **134B** includes fastening element **134C** designed to securely attach the engagement planar member **134B** to the underside of the upper containment unit **120.** The fastening element **134C** may comprise any suitable type of secure and removably attachable means, such as, for example, rotatable twist locking mechanisms, threaded bolts/nuts, *etc.* The fastening element **134C** is aligned with a complimentary aperture (not shown) and/or a positioning plate (not shown) of the underside of the upper containment unit **120** and rotated or screwed to lock into position with the complimentary aperture. In certain implementations, the engagement planar member **134B** may be equipped with one or more rectangular guiding plates **134D** extending vertically upwards from planar member **134B** to assist in the precise alignment of the upper containment unit **120** onto the bracket member **134** of the first support structure **130** and allow accurate placement of the complimentary aperture that is designed to mate with the fastening element **134C.** For added mechanical attachment strength, the rectangular guiding plates **134D** may incorporate apertures (not shown) to enable additional fastening elements, such as, bolt/nut combinations, to further secure the upper containment unit **120** onto the bracket member **134.**

Moreover, as noted above, the cross member **134A** of bracket member **134** incorporates flanged coupling portions at both ends. As discussed in detail below, the flanged coupling portions of cross member **134A** allow for the mechanical attachment of another frame member to form a second support structure **150.**

As also shown in FIG. 2A, the main frame member **132** of the first support structure **130** incorporates footplate members **132D, 132E** that are configured, and operate, to establish a stable base foundation for the first support structure **130.** Each of the footplate members **132D, 132E** are fixedly attached to a bottom end of a respective leg forming the A-shaped main frame member **132.**

While the depicted footplate members **132D**, **132E** are shown to manifest a rectangular shape, it will be appreciated that other configuration shapes of footplate members **132D, 132E,** such as, for example, circular, elliptical, triangular, hexagonal, may be employed provided that such other configurations are capable of providing a stable base foundation.

In certain embodiments, a positioning plate **140** is used to provide accurate placement of first support structure **130.** As best seen in the enlarged perspective view cutout of footplate member **132** in FIG. 2A, one of the footplate members **132D** of the first support structure **130** is mounted to a positioning plate **140.**

The positioning plate **140** incorporates one or more upwardly protruding anchor elements **140A**, **140B**. The upwardly protruding anchor elements **140A**, **140B** of positioning plate **140** serve to securely couple the first support structure **130** to an underside portion of the lower containment unit **110.**

That is, as best seen in the depicted embodiment of FIG. 2B, one of the upwardly protruding anchor elements **140A** of the positioning plate **140** operates to mate and engage a complementary-shaped aperture (not shown) on the underside corner portion of the lower containment unit **110.** The protruding anchor elements **140A**, **140B** may be configured with a wing-shaped profile having a rotatable, threaded portion to facilitate the locked coupling of the first support structure **130** to an underside portion of the lower containment unit **110.** It will be appreciated that the protruding anchor elements **140A**, **140B** may manifest other suitable shapes, profiles, and locking structures to provide the secure coupling of the first support structure **130** to an underside portion of the lower containment unit **110.** The protruding anchor elements **140A, 140B** operate to ensure that the complementary-shaped aperture (not shown) on the underside corner portion of the lower containment unit **110** is properly aligned and positioned accordingly.

In certain circumstances, such as, for example, maintenance/repair operations, fluid leakage/clean up services, etc. it may be advantageous to have one of the lateral sides of the lower containment unit **110** vertically tilted. For such purposes, tilting plates **142** may be implemented to raise a lateral side of the lower containment unit **110** that is supported by a corresponding first support structure **130** and positioning plate **140.**

Accordingly, as shown by the depicted embodiment of FIG. 2B, tilting plates **142** may be installed on the positioning plate **140** to vertically tilt the corresponding lateral side of the lower containment unit **110.** The tilting plates **142** are configured to have a vertical thickness of approx. 1 mm to approx. 10 mm. The number of tilting plates **142** implemented depends on the desired vertical displacement height and/or desired tilt angle of the lower containment unit **110** lateral side. The tilting plates **142** may be installed through insertion, sliding, or wedging between the top facing surface of positioning plate **140** and the interfacing bottom surface of the lower containment unit **110.**

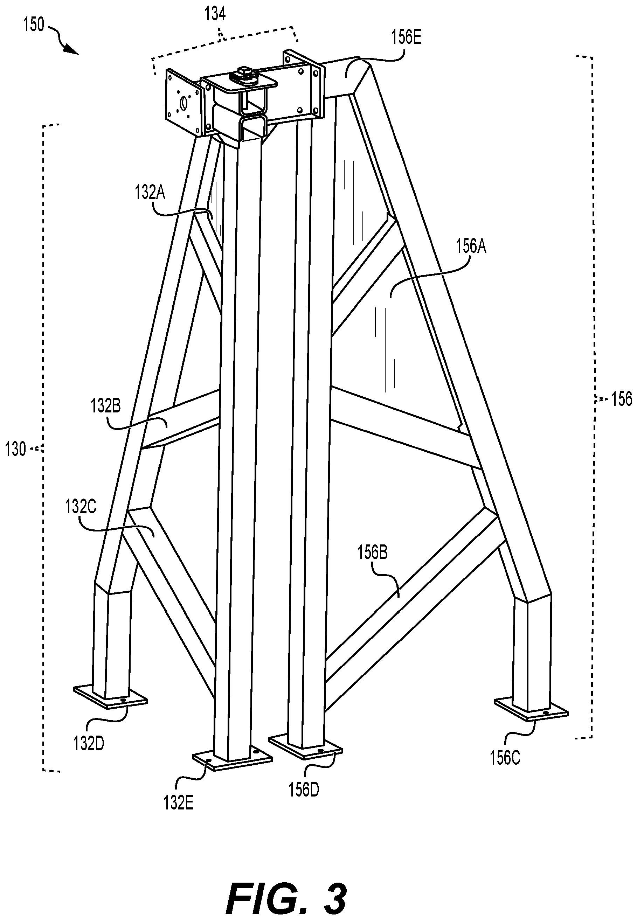

FIG. 3 depicts a perspective view of a second support structure **150,** in accordance with non-limiting embodiments of the present disclosure. The second support structure **150** is configured, and operates, to support an underside portion of one or more corners of the upper containment unit **120.** As shown, the second support structure **150** comprises the combination of the first support structure **130** and a second frame member **156.** As detailed above, the first support structure **130** includes a footplate member **132D** that is mounted to a positioning plate **140** which incorporates upwardly protruding anchor elements **140A, 140B** to provide the secure coupling the first support structure **130** to an underside portion of the lower containment unit **110.** With this said, and for the sake of brevity, the specific details of the first support structure **130** as described above are relied upon, except when necessary for clarification purposes.

In the depicted nonlimiting embodiment of FIG. 3, the second frame member **156** of the second support structure **130** also manifests a general "A-shaped" configuration having one or more cross brace members and/or panels **156A, 156B** disposed between the respective vertical legs forming the A-shaped configuration. The A-shaped configuration of second frame member **156** provides stability and strength capable of handling the weight bearing force imparted by the corner portions of the upper containment unit **120.** It will be appreciated that other shape configurations/designs of the second frame member **156** may be employed, provided that such other configurations are capable of handling the weight bearing force of upper containment unit **120.**

As shown, a top end of the A-shaped second frame member **156** is securely fastened to the bracket member **134** of the first support structure **130.** In particular, as noted above, the bracket member **134** incorporates flanged coupling portions on both sides of the cross member **134A** to facilitate mechanical attachment. Accordingly, depending on the orientation of the corner portions of the upper containment unit **120,** the second frame member **156** is securely fastened to one of the flanged coupling portions of the cross member **134A** of bracket member **134** in order for the second frame member **156** to assist in supporting the weight bearing forces imparted by the upper containment unit **120** and any horizontal forces that may compromise stability. The fastening of the second frame member **156** to one of the flanged coupling portions of the cross member **134A** may comprise any suitable type of secure and removably attachable means, such as, for example, threaded screws/bolts and nuts. In certain implementations, gusset plates that extend between the connecting plate of the frame member **156** and a horizontal prolongation **156E** may be incorporated to increase the mechanical strength of frame member **156.**

Moreover, the second frame member **156** of the second support structure **150** incorporates footplate members **156C, 156D** that are configured, and operate, to establish a stable base foundation for the second support structure **150.** Each of the footplate members **156C, 156D** are fixedly attached to a bottom end of a respective leg forming the A-shaped second frame member **156.** While the depicted footplate members **156C, 156D** are shown to manifest a rectangular shape, it will be appreciated that other configuration shapes of footplate members **156C, 156D,** such as, for example, circular, elliptical, triangular, hexagonal, may be employed provided that such other configurations are capable of providing a stable base foundation.

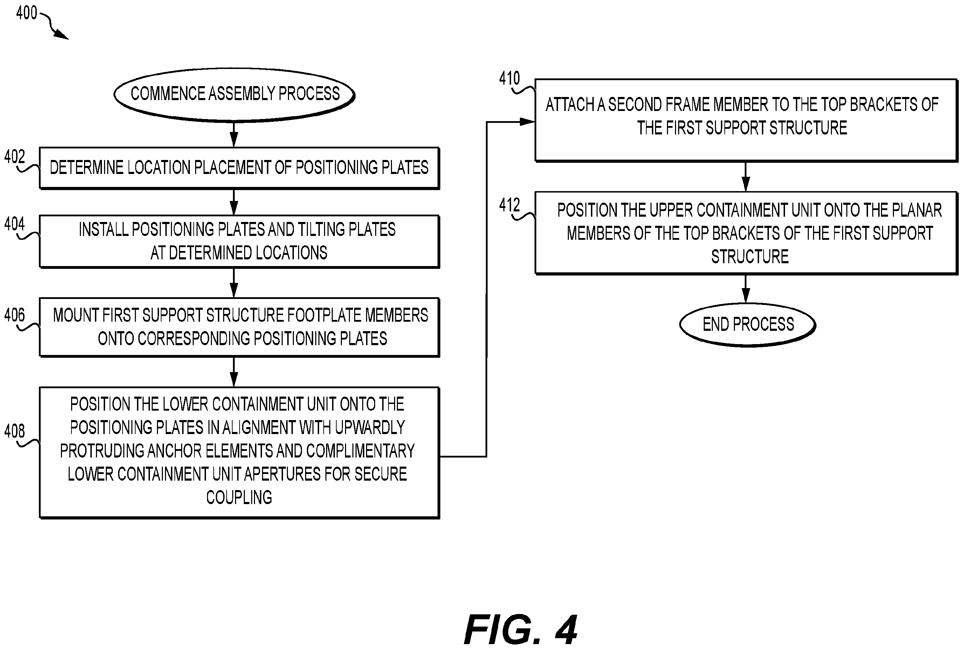

FIG. 4 illustrates a method of assembly for a multilevel modular datacenter configuration **400,** in accordance with non-limiting embodiments of the present disclosure. The assembly method **400** commences at step **402** in which the location placement of the positioning plates **140** is determined. The determination of the location placement of the positioning plates **140** may be based on a variety of measurements, such as, for example, the footprint or dimensions of the lower containment unit **110,** the location of the corner portions of the lower containment unit **110,** *etc.*

At step **404,** the positioning plates **140** and tilting plates **142** are installed at the determined placement locations corresponding to the corner portions of the lower containment unit **110.** As noted above, tilting plates **142** may be implemented to raise a lateral side of the lower containment unit **110** that is supported by a corresponding first support structure **130** and positioning plate **140.**

At step **406,** footplate members **132D** of the first support structures **130** are mounted onto corresponding positioning plates **140.** As noted above, the first support structure **130** as well as the second support structure are configured to configured, and operate, to raise the upper containment unit **120** above the lower containment unit **110** without any weight bearing forces imparted onto the lower containment unit **110.**

At step **408,** the lower containment unit **110** is positioned onto the positioning plates **140** such that the upwardly protruding anchor elements **140A** of the positioning plates **140** are aligned to engage complementary-shaped apertures on the underside corner portions of the lower containment units **110** to securely couple the first support structure **130** to the lower containment unit **110.**

At step **410,** the second frame members **156** are attached and securely fastened to corresponding top bracket members **134** of the first support structures **130** to provide a combined reinforcing support for the weight bearing corner portions of the upper containment unit **120** that is to be vertically raised above the lower containment unit **110.**

At step **412,** the upper containment unit **120** is positioned on top of the engagement planar members **134B** of the bracket members **134** of the first support structures **130** to establish a multilevel modular datacenter configuration in which lower containment unit **110** and upper containment unit **120** are vertically arranged and positionally secured without any weight bearing forces from the upper containment unit **120** imparted onto the lower containment unit **110.**

In this manner, the disclosed embodiments provide configuration and assembly of a multilevel modular datacenter capable of performing high volume data processing operations within a relatively limited footprint.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A multi-level modular datacenter (100), comprising:
a lower containment unit (110) configured to house at least one of a first assembly of data processing equipment and/or supporting infrastructure equipment;
an upper containment unit (120) configured to house at least one of a second assembly of data processing equipment and/or supporting infrastructure equipment, the upper containment (120) unit arranged to be aligned and vertically disposed directly above the lower containment unit (110);
at least one first support structure (130) configured to support a respective underneath area of a lateral side portion of the upper containment unit (120);
at least one second support structure (150) configured to support a respective underneath area of a corner portion of the upper containment unit (120);
the at least one first and second support structures are arranged to:
raise the upper containment unit directly above the lower containment unit (110) and receive all weight bearing forces of the upper containment unit (120), and
provide a protective vertical isolation gap (105) between the lower (110) and upper containment (120) units.

2. The multi-level modular datacenter of claim 1, wherein the protective vertical isolation gap (105) comprises a vertical height displacement between approximately 100mm to approximately 500mm to provide a preventative air layer against the spread of fire, water, and/or electrical hazards between the lower and upper containment units.

3. The multi-level modular datacenter of claims 1 or 2, wherein the at least one first support structure (130) further comprises:
a bracket member (134) incorporating a cross member (134A) having flanged coupling portions disposed at both ends of the cross member; and
an engagement planar member (134B) fixedly attached to the cross member (134A), the engagement planar member configured to directly interface and supportively engage the respective underneath area of the lateral side portion of the upper containment unit.

4. The multi-level modular datacenter of claim 3, wherein the engagement planar member (134B) includes at least one fastening element (134C) for securely attaching the engagement planar member to the underside lateral portion of the upper containment unit.

5. The multi-level modular datacenter of claim 3, wherein the bracket member (134) includes at least one rectangular guiding plate (134D) extending vertically upwards from the engagement planar member (134B) to guide the upper containment unit onto precise alignment with the bracket member (134).

6. The multi-level modular datacenter of any one of claims 3 to 5, wherein the at least one first support structure (130) incorporates at least one footplate member (132D, 132E) fixedly attached to a bottom end of each respective leg forming the configuration of the at least one first support structure.

7. The multi-level modular datacenter of claim 6, wherein the at least one footplate member (132D, 132E) includes an extended portion to securely couple the at least one first support structure to an underside portion of the lower containment unit.

8. The multi-level modular datacenter of claim 6 or 7, wherein the at least one footplate member (132D, 132E) is mounted to a positioning plate (140) that incorporates upwardly protruding anchor elements of positioning plate that serve to securely couple the first support structure to an underside portion of the lower containment unit.

9. The multi-level modular datacenter of claim 8, wherein the positioning plate is configured to accommodate one or more tilting plates (142) for lifting and tilting a side of the lower containment unit accordingly.

10. The multi-level modular datacenter of claim 9, wherein the one or more tilting plates (142) comprise a vertical height displacement of approximately 1mm to approximately 10mm.

11. The multi-level modular datacenter of any one of claims 4 to 10, wherein the at least one second support structure (150) comprises a combined arrangement between the at least one first support structure (130) and a second frame member (156).

12. The multi-level modular datacenter of claim 11, wherein the second frame member (156) is securely fastened to one of the flanged coupling portions of the bracket member (134) of the at least one first support structure (130).

13. The multi-level modular datacenter of claim 12, wherein the secure fastening of the second frame member to one of the flanged coupling portions of the bracket member comprises a threaded bolt and nut combination.

14. An assembly method for a multilevel modular datacenter configuration comprising a lower containment unit and an upper containment unit disposed above the lower containment unit, the assembly method comprising:
determining location placement of positioning plates in accordance with dimensions and location of corner portions of the lower containment unit;
determining location placement of tilting plates in accordance with lateral sides of the lower containment unit;
installing the positioning plates and tilting plates at the determined placement locations;
mounting footplate members of first support structures onto the corresponding positioning plates;
positioning and securely coupling the lower containment unit onto the positioning plates with the correspondingly mounted footplate members of the first support structures;
attaching and securely fastening second frame members to the first support structures to provide second support structures that support the upper containment unit; and
positioning and securely coupling the upper containment unit onto the second support structures, such that the upper containment unit is isolated from imparting any weight bearing forces onto the lower containment unit.

15. The multilevel modular datacenter assembly method of claim 14 further comprising:
arranging the positioning of the upper containment unit onto the second support structures, such that the upper containment unit is separated from the lower containment unit by a protective vertical isolation gap.
